# EUROPEAN PATENT APPLICATION

(11) **EP 1 519 481 A1**
(43) Date of publication of application: **30.03.2005**
(21) Application number: 03733580.9
(22) Date of filing: 27.06.2003
(51) Int. Cl.: H03G 3/20, H03F 3/45

(54) **AGC CIRCUIT**

(30) Priority: 03.07.2002 JP 2002194406
(71) Applicant: Kabushiki Kaisha Toyota Jidoshokki, Kariya-shi, Aichi 448-8671 (JP); Niigata Seimitsu Co., Ltd., Niigata 943-0834 (JP)
(72) Inventor: Miyagi, Hiroshi, Niigata Seimitsu Co., Ltd., Joetsu-shi, Niigata 943-0834 (JP)
(74) Representative: Leson, Thomas Johannes Alois, Dipl.-Ing.
(86) International application number: PCT/JP2003/008225
(87) International publication number: WO 2004/006430

(57) **Abstract**

The AGC circuit that is provided in an RF receiver is equipped with the detection circuit that detects a high frequency reception signal andoutputs the detection signal including a pulsating component and implements the gain control on an RF amplification circuit according to the detection output. The amplifier (DC amplifier) that is connected immediately after the detection circuit is configured to be deteriorated in its high frequency property or a unit that deteriorates the high frequency property is connected to the amplifier. According to such a configuration, the pulsating component that is overlapped with the detection output is removed as much as possible.

## Description

### Technical Field

The present invention relates to an AGC (Automatic Gain Control) circuit provided in an RF (radio frequency) receiver and especially relates to the improvement to prevent a pulsating component generated at the detection stage of the circuit from exerting an influence on the AGC control.

### Background Art

Conventionally, the intended station (intended frequency) of a reception signal received by an antenna is selected by a tuned circuit in the RF receiver of a general superheterodyne system and this signal is supplied to a mixer via an RF amplification circuit. The signal that is outputted from the mixer is converted into an intermediate frequency signal. After the thus-converted signal is demodulated by the demodulator that is provided at the subsequent stage of the mixer, the sound is reproduced. The RF receiver is configured in such a way that the AGC circuit is provided at the subsequent stage of an RF amplification circuit provided in the RF receiver. Therefore, this receiver automatically controls the gain of the RF amplification circuit in accordance with the reception signal level so that it can obtain a constant output.

In the conventional AGC circuit, however, there is a problem such that a pulsating component is overlapped with the detection output signal of a detection circuit that is used in the AGC circuit. Since such a pulsating component leaks from the detection circuit, the conventional AGC circuit has a disadvantage such that the distortion by the AGC circuit increases and this distortion exerts a bad influence on an AGC control.

Furthermore, since the AGC circuit generally includes a continuation feedback system, a certain time period is required from the detection of a baseband signal using the detection circuit until the implement of an AGC control on a reception signal using the RF amplification circuit. Consequently, the AGC circuit greatly receives the influence of the pulsating component that leaks from the detection circuit.

Furthermore, in the case where the AGC circuit provided in the RF receiver is made IC-compatible, the pulsating component that leaks from the detection circuit is easily inputted into the RF amplification circuit as mentioned above and this inputted pulsating component is modulated togethe rwith the intended reception signal, thereby generating distortion.

### Disclosure of Invention

The subject of the present invention is to prevent as much as possible the influence caused by the pulsating component that leaks from a detection circuit in the AGC circuit provided in an RF receiver

The present invention is configured as follows, in order to achieve the above-mentioned subject.

The present invention provides an AGC circuit comprising a detection circuit that detects a high frequency reception signal and outputs a detection signal including a pulsating component, and controlling a gain of an amplification circuit amplifying the high frequency reception signal in accordance with a detection output of this detection circuit, wherein the high frequency property of the amplifier that is connected immediately after the detection circuit is deteriorated or a unit for deteriorating the high frequency property is connected to the amplifier.

In this way, by deteriorating the high frequency property of the amplifier that is connected immediately after the detection circuit or by connecting the unit for deteriorating the high frequency property to this amplifier, it becomes possible not only to amplify a detection signal using the amplifier but also to effectively remove the pulsating component of a high frequency that leaks from the detection circuit. Therefore, the bad influence on an AGC control by the pulsating component is prevented as much as possible. Meanwhile, thepulsatingcomponentneednotbecompletely removed and it is sufficient to remove the component to the extend that the influence on the AGC control is improved. In order to sufficiently remove the pulsating component, for example, it is desirable to deteriorate the high frequency property up to the degree that the gain in a frequency of the pulsating component attenuates by an amount equal to or greater than 3dB in comparison with the gain in a DC current (frequency=0).

Meanwhile, it is possible to adopt various configurations as a configuration of the amplifier for deteriorating the high frequency property in this way and a configuration of the unit for deteriorating the high frequency property but desirable examples are as follows:

The first example shows a configuration such that a channel length and a channel width in each MOSFET that configures the amplifier are set large up to the degree that the high frequency property of the amplifier deteriorates.

The second example shows a configuration such that a capacitor with large capacity is connected between an output terminal of the amplifier and the ground.

The third example shows a smoothing circuit comprising a capacitor, a voltage comparison circuit for comparing a terminal voltage with an input voltage of the capacitor, a charging circuit for charging the capacitor at intervals in the case where the input voltage is relatively higher than the terminal voltage and a discharging circuit for discharging a discharge current from the capacitor at intervals in the case where the terminal voltage is relatively lower than the input voltage. This smoothing circuit is connected to an output terminal of the amplifier.

The fourth example shows a configuration such that a wiring capacity is increased up to the degree that the high frequencypropertyof the amplifierdeteriorates by arranging the respective MOSFETs configuring the amplifier in such a way that these wirings are mutually crossed.

According to the AGC circuit of the present invention, by deteriorating the high frequency property of the amplifier that is connected immediately after the detection circuit (or by connecting a unit for deteriorating the high frequency property to the amplifier), the pulsating component that is mixed into an AGC control signal is effectively removed so that the distortion due to the influence of the pulsating component can be prevented as much as possible. Therefore, according to the present invention, a gain control on the RF amplification circuit can be accurately materialized without exerting an influence on the reception operation of a signal that is received by the RF receiver

Furthermore, the amplifier and the detection circuit can be integrated into an IC. Thus, the whole circuit can be integrated into an IC without greatly complicating the configuration of the circuit.

### Brief Description of the Drawings

Fig. 1 is a circuit diagram showing the main part of an RF receiver provided with an AGC circuit 200 according to one preferred embodiment of the present invention;
Fig. 2 is a circuit diagram showing the first main part that configures DC amplifiers 18 and 19;
Fig. 3 is a layout diagram of MOSFET and a wiring in a differential amplification circuit group 20;
Fig. 4 is a circuit diagram showing one example of the second main part in DC amplifiers 18 and 19;
Fig. 5 is a circuit diagram showing another example of the second main part in DC amplifiers 18 and 19; and
Fig. 6 is a specific circuit diagram of a smoothing circuit 25.

### Best Mode for Carrying Out the Invention

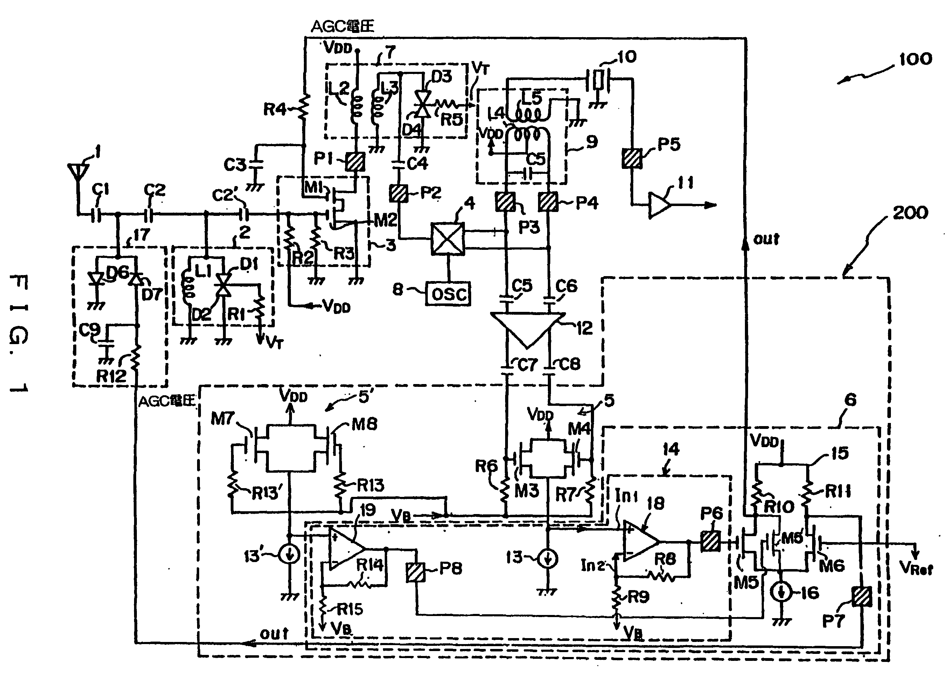

Fig. 1 is a circuit diagram of an RF receiver 100 provided with the AGC circuit 200 according to one preferred embodiment of the present invention;

Here, the RF receiver 100 shows one example of adopting a superheterodyne system. Here, the RF receiver 100 is provided with the AGC circuit 200. This AGC circuit 200 is a circuit for controlling the gain of an RF amplification circuit 3 according to the level of the high frequency reception signal received from an antenna 1.

First of all, the configuration of the RF receiver 100 and the operation of each circuit that is included in this receiver are explained.

In the RF receiver 100, first of all, a DC component is removed from the high frequency reception signal that is received from the antenna 1 using capacitors C1 and C2 (high-pass filter: HPF) and the signal of a high frequency bandpass is extracted. Then, a signal of the intended frequency is extracted using a tuned circuit 2 and the DC component of the signal of the intended frequency is removed using a capacitor C2' (high-pass filter: HPF). Subsequently, the thus-removed signal is amplified using an RF (Radio Frequency) amplification circuit 3 to be supplied to a mixer 4. The signal that is outputted from the mixer 4 is converted into an intermediate frequency signal. After this signal is detected by a detector that is not shown in the drawings and the thus-detected signal is demodulated, the sound is reproduced.

Furthermore, the intermediate frequency signal is also outputted to the AGC circuit 200 according to one preferred embodiment of the present invention and it controls the gain of the RF amplification circuit 3. The intermediate frequency signal that is inputted into the AGC circuit 200 (including a high frequency component as described later) is detected by an amplitude detection circuit 5 and an AGC drive circuit 6 controls the gain of the RF amplification circuit 3 on the basis of this detection output.

The tuned circuit 2 includes a tuned coil L1, a varactor diode including two diodes (D1, D2) and a resistor R1. One end of the tuned coil L1 and that of a diode D1 are connected to a gate (G) of the second MOSFET (M2) that is described later. The two diodes (D1, D2) that configure the varactor diode are connected at the cathodes while the anode of the diode D2 is connected to the ground. Furthermore, one end of the resistor R1 is connected to the cathodes of the two diodes (D1, D2) and the other end supplies a voltage VT for tuning.

The RF amplification circuit 3 is provided with the first MOSFET (M1) and the second MOSFET (M2). The first MOSFET (M1) and the second MOSFET (M2) are configured to be cascade-connected. Furthermore, a drain voltage VDD is applied via a resistor R2 between the gate (G) and the source (S) of the second MOSFET (M2). The gate (G) of the second MOSFET (M2) is connected to the ground via a resistor R3 and the source (S) is further connected to the ground.

The gain of the RF amplification circuit 3 is controlled by inputting into the gate (G) of the first MOSFET (M1), the gain control current that is outputted from the AGC circuit 200 that is described later. A resistor R4 and a capacitor C3 are provided to remove a pulsating component that is included in the gain control current. In this way, the stable voltage supply can be implemented between a gate and a drain of the first MOSFET (M1).

Then, the reception signal of a high frequency bandpass is inputted into the gate (G) of the second MOSFET (M2) using the capacitors (C1 and C2). After the inputted signal is amplified using the second MOSFET (M2), this signal is outputted form the drain (D) to be inputted into the source (S) of the first MOSFET (M1). For the signal that is inputted into the source(S), an AGC control is implemented using the gain control current in the first MOSFET (M1). This signal is outputted after the amplitude gain restriction in a high frequency region is implemented.

Here, pads are arranged at square parts (P1 from P8), for example, as shown in Fig. 1. The pad is a region used for externally mounting an element, such as a capacitor, etc. If there is not a necessity for externally mounting an element, the pad at this region need not be provided.

The drain (D) of the first MOSFET (M1) is connected to the first coil L2 of a tuned circuit 7.

The tuned circuit 7 includes the first coil L2, a tuned coil L3, two diodes (D3 and D4) configuring a varactor diode and a resistor R5. One end of the tuned coil L3 and that of the diode D3 are connected to a capacitor C4. Furthermore, the two diodes D3 and D4 are connected at the cathodes and the anode of the diode D4 is connected to the ground.

The signal that is outputted from the tuned circuit 7 is outputted to the mixer 4 at the subsequent stage via the capacitor C4. Furthermore, one end of the resistor R5 is connected to the cathode parts of the diodes (D3 and D4) and a voltage VT for tuning is supplied from the other end of the resistor R5. Furthermore, a drain voltage VDD is applied to the drain (D) of the first MOSFET (M1) via the first coil L2.

An intended local oscillation signal is supplied to the mixer 4 from a local oscillation circuit (OSC) 8, the mixer 4 mixes the output signal that is outputted from the tuned circuit 7 with the local oscillation signal and two intermediate frequency signals such that two phases thereof that have intermediate frequencies are deviated by π from each other are outputted. Then, the two intermediate frequency signals that are outputted from the mixer 4 are separated into two directions.

Namely, one of the intermediate frequency signals is inputted into a bandpass filter (BPF) 9 and then it is supplied to a crystal filter 10. The signal that is outputted from the crystal filter 10 is intermediate-frequency-amplified using an intermediate frequency amplification circuit 11. The thus-intermediate-frequency-amplified signal is supplied to a stereo demodulation circuit (not drawn) via an FM detection circuit (not drawn).

The bandpass filter (BPF) 9 includes a first coil L4, a second coil L5 and a capacitor C5. In the bandpass filter (BPF) 9, the first coil L4 and the capacitor C5 are connected in parallel and both ends of the first coil L4 and those of the capacitor C5 are configured to be connected to the mixer 4. Also, a drain voltage VDD is applied to the first coil L4. Furthermore, one end of the second coil L5 is connected to the ground and the other end is connected to the crystal filter 10.

Also, the other intermediate frequency signal is outputted to the AGC circuit 200 for controlling the gain of the RF amplification circuit 3 (this AGC circuit 200 is described later). Here, the capacitors (C5, C6, C7 and C8) are arranged while connected in series at the previous stage and at the subsequent stage of a buffer amplifier 12. The buffer amplifier 12 is provided in order that the changes of the impedances due to the electric fluctuations of both the amplitude detection circuit 5 that is arranged at the subsequent stage of the mixer 4 and the bandpass filter 9 do not occur mutually by the output signal from the mixer 4.

The AGC circuit 200 includes amplitude detection circuits 5 and 5' and the AGC drive circuit 6 (amplifiers 18 and 19, and a buffer amplifier 15).

The signal that is outputted from the mixer 4 passes the buffer amplifier 12 that is provided at the previous stage of the amplitude detection circuit 5 and then this signal is inputted into the amplitude detection circuit 5. The amplitude detection circuit 5 detects the amplitude level of this inputted signal and outputs a detection signal.

Here, the configurations and the operations of the amplitude detection circuits 5 and 5' are explained.

The amplitude detection circuit 5 includes two MOSFETs (M3 and M4) and two resistors (R6 and R7), etc. A drain voltage VDD is applied to each of the drains of the two MOSFETs (M3 and M4). The two MOSFETs (M 3 and M4) are, for example, N channel MOSFETs.

Furthermore, a bias voltage VB is applied to each of the gates (G) of the two MOSFETs (M3 and M4) via resistors (R6 and R7). In addition, the resistors (R6 and R7) assign proper bias voltages VB between the gates (G) and sources (S) of the two MOSFETs (M3 and M4).

The gates (G) of the two MOSFETs (M3 and M4) are connected to the buffer amplifier 12 and two intermediate frequency signals each having phases deviated from the mixer 4 by π are inputted into the gates (G). The sources (S) of the two MOSFETs (M3 and M4) are mutually connected (intermediate node).A high frequency signal (carrier wave) is included in the signal that is inputted into the amplitude detection circuit 5. By implementing half-wave ratification and full-wave ratification to this high-frequency signal, the detection signal including a pulsating component is outputted. This detection signal is outputted (In1) from the intermediate node of the amplitude detection circuit 5 to a noninversion input terminal (+) of the DC amplifier 18 configuring the AGC drive circuit 6 that is arranged at the subsequent stage of the amplitude detection circuit 5. Furthermore, the intermediate node is connected to the ground via a constant current circuit 13.

The other amplitude detection circuit 5' has the circuit configuration similar to that of the amplitude detection circuit 5 and the former circuit includes two MOSFETs (M7 and M8) and two resistors (R13 and R13'), etc. A drain voltage VDD is supplied to each of the drains (D) of the two MOSFETs (M7 and M8) and a bias voltage VB is supplied to the gate (G) via resistors (R13 and R13').

Additionally, in the amplitude detection circuit 5', the sources (S) of the two MOSFETs (M7 and M8) are connected (intermediate node) to each other. Furthermore, the intermediate node of the amplitude detection circuit 5' is connected to the ground via the constant current circuit 13'.

Then, in the amplitude detection circuit 5', a bias current is outputted from the intermediate node of the amplitude detection circuit 5' to the noninversion input terminal (+) of the DC amplifier 19 that is provided at the subsequent stage of the circuit as an output signal. In addition, the output terminal and inversion input terminal (-) of the DC amplifier 19 are connected via the resistor R14.

Then, the AGC drive circuit 6 includes a DC amplifier group 14, the buffer amplifier 15 and a resistor, etc. all of which are connected immediately after the amplitude detection circuits 5 and 5'.

In the two DC amplifiers (for example, operational amplifiers of a differential amplification circuit) 18 and 19 that configure the DC amplifier group 14, a configuration for restricting the amplitude gain of a high frequency region of the detection signal that is outputted from each of the amplitude detection circuits 5 and 5' is provided as a characteristic of the present invention. In this configuration, the pulsating component that is included in this detection signal is removed as much as possible. This processing is described later.

In one DC amplifier 18, a bias voltage VB is inputted (In2) into the inversion input terminal (-) via a resistor R9 and a detection signal from the amplitude detection circuit 5 is inputted (In1) into the noninversion input terminal (+) so that the DC component of this detection signal is amplified by the DC amplifier 18. Also in the other DC amplifier 19, a bias voltage VB is inputted into the inversion input terminal (-) via a resistor R15. In addition, the detection signal from the amplitude detection circuit 5' is inputted into the noninversion input terminal (+) and the DC component of this detection signal is amplified by DC the amplifier 19. Here, the amplification operations in the respective DC amplifiers 18 and 19 are similar as those of the publicly-known operational amplifiers. Namely, in the DC amplifier 18, the resistor (negative feedback resistor) R8 is connected so as to configure a negative feedback circuit and the detection signal is inputted (In1) from the amplitude detection circuit 5 into a noninversion input terminal (+). Then, the DC component is amplified (amplification rate: R8/R9) to be outputted. Additionally, a feedback current If flows into the resistor R8 to be inputted into an inversion input terminal (-). The distortion of the inputted signal that is generated in the DC amplifier 18 is removed by this feedback current If. Such operations are similar to those of the other DC amplifier 19.

Then, the respective output signals of the DC amplifiers 18 and 19 are outputted to the buffer amplifier 15 of the high input impedance that is provided at the subsequent stage of each of the DC amplifiers. This buffer amplifier 15 outputs a gain control current (DC control current) that controls the gain of the RF amplification circuit 3. The buffer amplifier 15 controls the gain of the RF amplification circuit 3 using the gain control current while preventing the gains of the DC amplifiers 18 and 19 from being changed by the load on the DC amplifier group 14.

Here, the buffer amplifier 15 includes, for example, two MOSFETs (M5 and M 5') that are connected in parallel, another MOSFET (M6) that corresponds to these MOSFETs in respect of differential, resistors (R10 and R11), etc. These units configure a differential amplification circuit. Meanwhile, the MOSFETs (M5, M 5' and M6) are, for example, N channel MOSFETs.

In the buffer amplifier 15, a drain voltage VDD is applied to each of the drains of the two MOSFETs (M5 and M5') via the resistor (R10) and at the same time, this drain voltage VDD is applied to the drain of the other MOSFET (M6) via the resistor (R11). The output signals of the DC amplifiers 18 and 19 are respectively inputted into the gates of MOSFETs (M5 and M5'). On the other hand, a standard constant voltage (AGC start voltage) VRef is inputted into the gate of MOSFET (M6). Furthermore, the respective sources of three MOSFETs (M5, M5' and M6) are connected mutually and they are connected to the ground via the constant current circuit 16.

The intermediate node among the drains of MOSFETs (M5 and M 5') and the resistor R10 is connected to the gate of the first MOSFET (M1) of the RF amplification circuit 3 and each of the MOSFETs outputs the signal (gain control currents) that implements a gain control on the RF amplification circuit 3, as mentioned before. Thus, the gain control on the RF amplification circuit 3 is implemented by supplying the gain control current that is outputted from the buffer amplifier 15 to the gate of MOSFET (M1) of the RF amplification circuit 3. That is, when many gain control currents flow into the MOSFET (M1), the drain voltage rises and accordingly the signal level rises. When a few gain control currents flow into the MOSFET (M1), on the other hand, the drain voltage drops and accordingly the signal level drops so that the signal level stabilizes at a constant level.

The intermediate node between the drain of MOSFET (M6) and the resistor R11 are connected to an AGC diode 17. The AGC diode 17 includes diodes (D6 and D7), a resistor R12 and a capacitor C9 as shown in Fig. 1 and controls a reception signal on the basis of the control signal that is supplied from the buffer amplifier 15. Here, the resistor R12 and the capacitor C9 are provided to remove a pulsating component from the control signal that is supplied to the AGC diode 17 from the buffer amplifier 15.

In this preferred embodiment of the present invention, the DC amplifiers 18 and 19 are uniquely configured (which is explained later) so as to remove a pulsating component but the pulsating component that is not removed even by this configuration and is included in each AGC control signal is removed by a circuit which includes the capacitor C9 and the resistor R12 or a circuit which includes the capacitor C3 and the resistor R4.

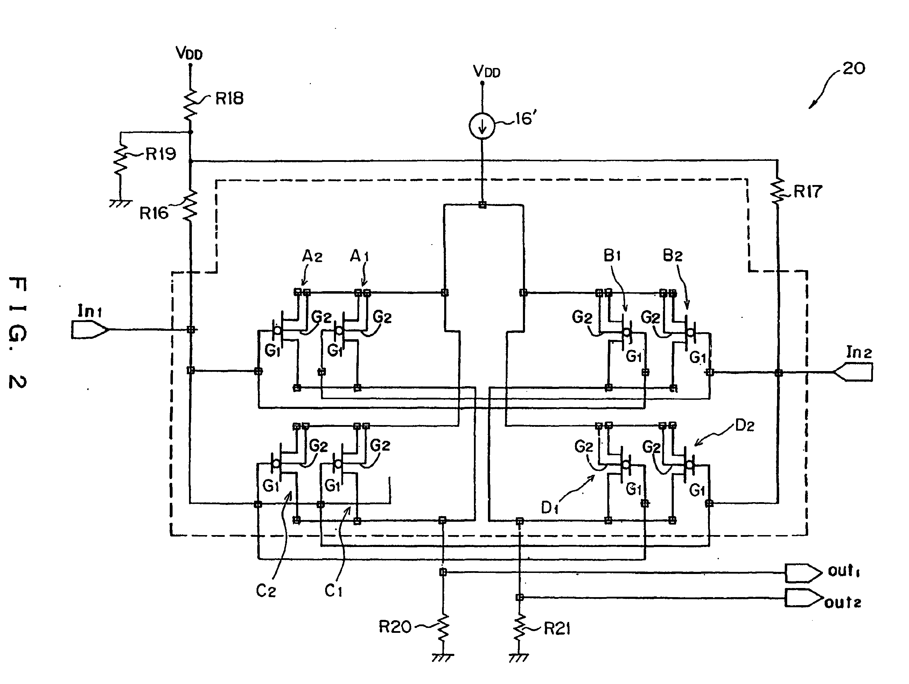

Fig. 2 is the circuit diagram showing the first main part of two main parts that configure the DC amplifiers 18 and 19 shown in Fig. 1.

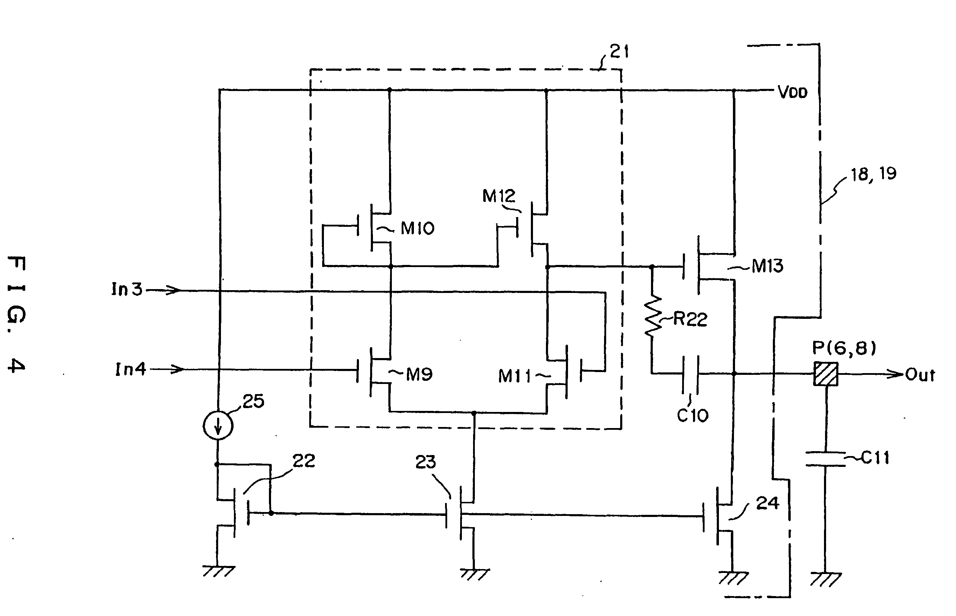

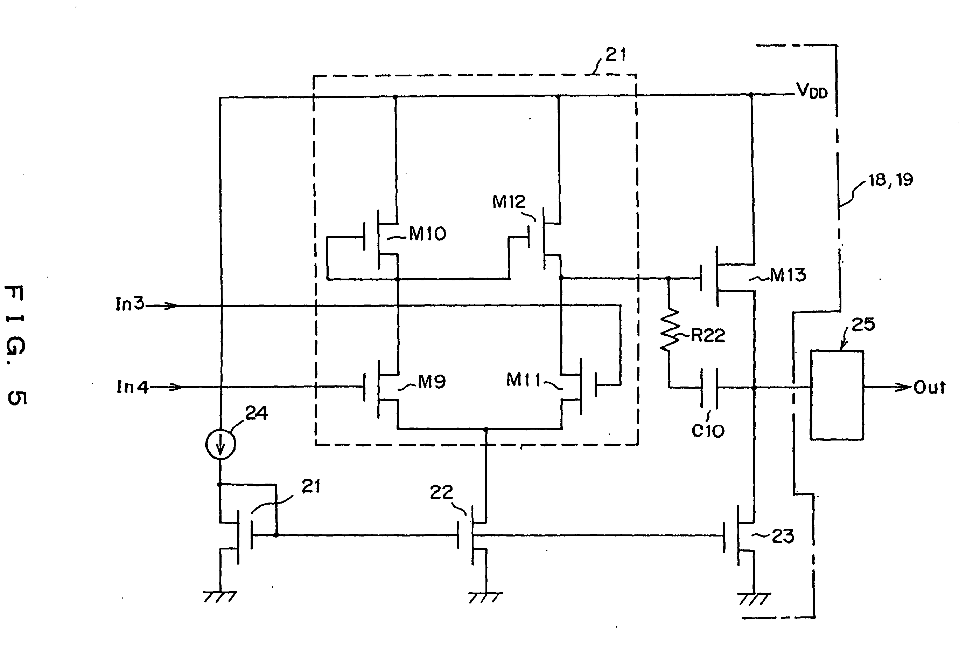

As shown in Fig.2, the circuit of the first main part configuring each of the DC amplifiers 18 and 19 includes the differential amplification circuit group 20 that is provided with a plurality of MOSFETs (A1 and A2, B1 and B2, C1 and C2, and D1 and D2), resistors R16 and R17, etc. The circuit of the second main part configuring each of the DC amplifiers 18 and 19 is explained using Figs. 4 and 5 that are explained later. Each MOSFET (A1 and A2, B1 and B2, C1 and C2, and D1 and D2) is, for example, P channel MOSFET. A drain voltage VDD is applied to each source (S) of the MOSFET (A1 and A2, B1 and B2, C1 and C2, and D1 and D2) via a constant current circuit 16'.

In1 and In2 (inputs) that are shown in the same drawing correspond to a noninversion input terminal (+) and an inversion input terminal (-), respectively in each of the DC amplifiers 18 and 19 that are shown in Fig. 1.

According to the configuration of the preferred embodiment of the present invention, the circuit of Fig. 4 or 5 is provided at the subsequent stage of the differential amplification circuit group 20. The output signal from OUT1 and that from OUT2 of Fig. 2 are outputted to In3 and In4 in Fig. 4 or Fig. 5, respectively. The circuit operation and also the circuit configuration of the input signals inputted into In3 and In4 are explained later using Figs. 4 and 5.

In the differential amplification circuit group 20, a MOSFETA1 corresponds to a MOSFETB1 while a MOSFETA2 corresponds to a MOSFETB2 and the corresponded units individually configure the differential amplification circuit. Furthermore, a MOSFETC1 corresponds to a MOSFETD1 while a MOSFETC2 corresponds to a MOSFETD2 to configure differential amplification circuits. In this way, these differential amplification circuits configure the differential amplification circuit group 20.

By symmetrically arranging these MOSFETs, the difference between ion densities depending on the position of each MOSFETs can be reduced in comparison with the difference between ion densities on an IC substrate, which is one of the subjects in manufacturing in the ion infusion process or in the diffusion process of the production processes of IC. Consequently, the effect of suppressing the errors in manufacturing can be obtained.

As mentioned above, since the difference among ion densities in manufacturing depending on the position of each transistor can be reduced, the effect of decreasing an offset voltage can be obtained. Furthermore, the overlap of wirings that connect each of differential amplification circuits (transistor A group and transistor B group, and transistor C group and transistor D group) in which transistors are arranged while being sandwiched to each other increases a wiring capacity. Therefore, a high frequency property can be deteriorated without using a capacitor (in other words, a pulsating component can be removed as much as possible).

Then, the respective detection signals from the amplitude detection circuits 5 and 5' are inputted (In1) into noninversion input terminals (+) of the DC amplifiers 18 and 19 while bias voltages VB are inputted (In2) into inversion input terminals (-) of the DC amplifiers 18 and 19. That is, detection signals are inputted (In1) into the gates (G1) of MOSFETs (A2 and B1) and MOSFETs (C2 and D1) while bias voltages VB are inputted (In2) into the gates (G1) of MOSFETs (A1 and B2) and MOSFETs (C1 and D2).

Furthermore, a drain voltage VDD is applied to an intermediate node between the resistor R16 and the resistor R17 via a resistor R18. Furthermore, a resistor R19 is connected to the intermediate node between the resistor R16 and the resistor R18. One end of the resistor R19 is connected to the ground.

Next, the output signal that is amplified using MOSFETs (A1 andA2) and MOSFETs (C1 and C2) is outputted to an output OUT1 from the drain (D). The output signal that is amplified using MOSFETs (B1 and B2) and MOSFETs (D1 and D2) is outputted to an output OUT2 from the drain (D).

Namely, the electric potentials of OUT1 and OUT 2 to the ground (in other words, voltages of the ends of resistors R20 and R21) are outputted as output voltages.

Each gate (G2) is connected to the source (S) side of each MOSFET as shown in the same drawing. The gate (G1) of a MOSFETA1 and the gate (G1) of a MOSFETB2 are connected while the gate (G1) of a MOSFETA2 and the gate (G1) of a MOSFETB1 are connected. Furthermore, the gate (G1) of a MOSFETC1 and the gate (G1) of a MOSFETD2 are connected while the gate (G1) of a MOSFETC2 and the gate (G1) of a MOSFETD1 are connected.

Here, for example, the MOSFETA1 and the MOSFETB1 are explained.

As mentioned before, one differential amplification circuit in the differential amplification circuit group 20 related to the present invention includes the MOSFETA1 and the MOSFETB1.

In the MOSFETA1 and the MOSFETB1 that configure the differential amplification circuit, an input signal In2 and an input signal In1 that are inputted from each gate (G1) of the respective MOSFETs are amplified in a known way. The input signal In2 is outputted to the OUT1 from the drain (D) of the MOSFETA1 while the input signal In1 is outputted from the OUT2 from the drain (D) of the MOSFETB1.

Namely, the signal level In2 that is inputted from the gate (G1) of the MOSFETA1 is amplified since the gain is obtained so that the amplified signal is outputted from the drain (D) to the output OUT1 as an output signal. In addition, a voltage VGS between the source (S) and the gate (G1) of the MOSFETA1 changes when an input signal is inputted from the gate (G1) so that a drain current (output signal) flows into the gate (G2) of the MOSFETA1. The output signal from the gate (G2) of the MOSFETA1 is outputted to the source (S) side of the MOSFETA1.

Furthermore, the signal level In1 that is inputted from the gate (G1) of the MOSFETB1 is amplified since the gain is obtained so that the amplified signal is outputted to the output OUT2 from the drain (D) as an output signal. In addition, a voltage VGS between the source (S) and the gate (G1) of the MOSFETB1 changes when an input signal is inputted from the gate (G1) so that a drain current (output signal) flows into the gate (G2) of the MOSFETB1. The output signal from the gate (G2) of the MOSFETB1 is outputted to the source (S) side of the MOSFETA1.

Therefore, the difference between the respective inputted signal levels (difference between the input signal In1 and the input signal In2) is amplified as the difference between outputted signals and then the amplified signal is outputted (respectively from the OUT2 and the OUT1).

In addition, regarding the MOSFETA2 and the MOSFETB2, the difference between the respective inputted signal levels (difference between the input signal In1 and the input signal In2) is amplified as the difference between outputted signals and the amplified signal is outputted (respectively from the OUT2 and OUT1), in the same way as mentioned above. In this way, a MOSFETA group and a MOSFETB group configure a differential amplification circuit.

Furthermore,a differentialamplification circuit including MOSFETs (C1 and C2) and MOSFETs (D1 and D2) is configured in the same way as the circuit including MOSFETs (A1 and A2) and MOSFETs (B1 and B2). Meanwhile, as for each MOSFET (A, B, C or D), for example, two MOSFETs such as MOSFETA1 and MOSPETA2 are respectively arranged. However, the number is not limited to two as long as the number is an even number.

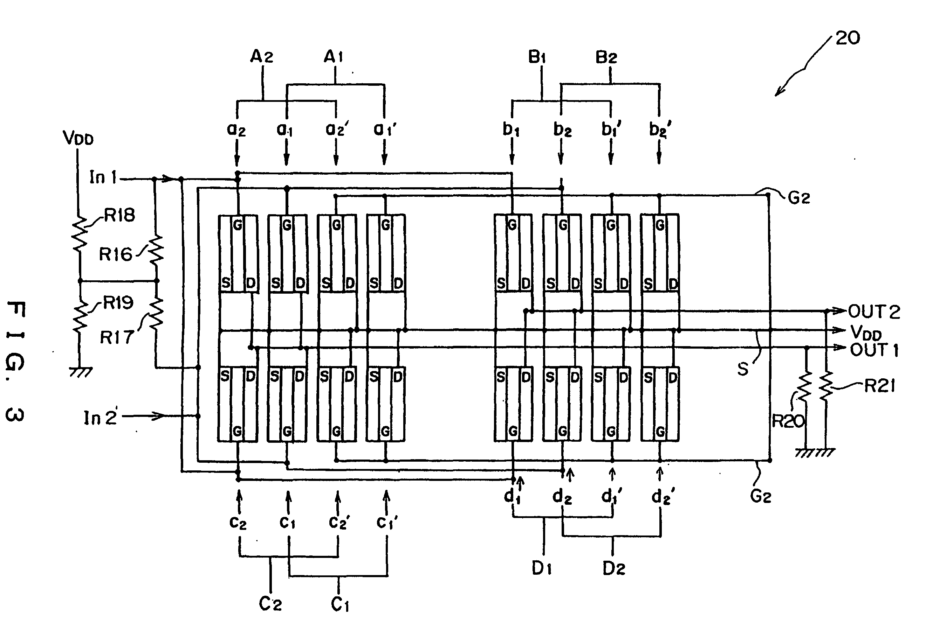

In this way, two MOSFETs configuring one differential amplification circuit in the differential amplification circuit group 20 are arranged while symmetrically sandwiching two MOSFETs configuring another adjacent differential amplification circuit. That is, two of MOSFETAn+1 and MOSFETBn+1 (n is a natural number) that configure one differential amplification circuit are arranged while they sandwich MOSFET An and MOSFET Bn (n is a natural number) that configure another differential amplification circuit. The overlap of wirings of the respectiveMOSFETs due to this arrangement causes the increase of a wiring capacity. Furthermore, by increasing a ratio (L/W) between a channel length (L) and a channel width (W) of each MOSFET that is mentioned in the explanation about Fig. 3 and by increasing a gate capacity by largely setting both a channel length (L) and a channel width (W), the effect of deteriorating a high frequency property can be obtained.

Fig. 3 is the layout diagram of MOSFET and also a wiring in differential amplification circuit group 20 as shown in Fig. 2.

In Fig. 3, the characteristic of the layout of the differential amplification circuit group 20 of Fig. 2 is explained. In Fig. 3, the same numerals as those shown in Fig. 2 indicate the same articles.

First of all, for example, as shown in the same drawing, transistors An (n is 1 and 2) that configure respective MOSFETs include transistors an and transistors an' (n is 1 and 2) that are the configuration elements of the transistors An. Furthermore, transistors Bn (n is 1 and 2) include transistors bn and transistors bn' (n is 1 and 2), transistors Cn (n is 1 and 2) include transistors cn and transistors cn' (n is 1 and 2) and transistors Dn (n is 1 and 2) include transistors dn and transistors dn' (n is 1 and 2).

Here, the transistors An (n is 1 and 2) are explained as a representative example.

As shown in Fig. 3, the transistor A1 (a1 and a1') is arranged while sandwiching a transistor a2' that is the configuration element of the transistor A2 (a2 and a2') that is adjacently arranged. In addition, the transistor A2 (a2 and a2') is arranged while sandwiching a transistor a1 that is the configuration element of the transistor A1 (a1 and a1').

Subsequently, the respective transistors of' transistors Bn (n is 1 and 2), transistors Cn (n is 1 and 2) or transistors Dn (n is 1 and 2) are arranged corresponding to each other in the same way as the arrangement of the transistors An.

Since the respective transistors are symmetrically arranged as far as on the layout, differential amplification circuits including the transistor A1 and transistor B1, and the transistor A2 and transistor B2 are explained as representative examples.

The differential amplification circuits which include the transistor C1 and the transistor D1, and the transistor C2 and the transistor D2 can be obtained by replacing the configuration element transistors (a1 and a1') of the transistors An (n is 1 and 2) with the configuration element transistors (c1 and c1') of the transistors Cn (n is 1 and 2) and replacing the configuration element transistors (b1 and b1') of the transistors Bn (n is 1 and 2) with the configuration element transistors (d1 and d1') of transistors Dn (n is 1 and 2), in the configuration element transistors (a1 and a1') of the transistors An (n is 1 and 2) and the configuration element transistors (b1 and b1') of the transistors Bn (n is 1 and 2).

First of all, a drain voltage VDD is applied to the source (S) of each transistor. In the transistors A1 and B1, an input signal In1 is inputted into the gate (G1) of the transistor b1 while an input signal In2 is inputted into the gate (G1) of the transistor a1. Furthermore, drain voltages VDD are applied to the gate (G2) of the transistor a1' and the gate (G2) of the transistor b1' in the same way as in the case of the source.

In addition, a drain voltage VDD is applied to the drain (D) of the transistor a1' and the drain (D) of the transistor b1' in the same way as in the case of the source. A drain voltage VDD is also applied to an intermediate node between the resistor R16 and the resistor R17 via the resistor R18. Furthermore, the resistor R19 is connected to an intermediate node between the resistor R16 and the resistor R18 and one end of the resistor R19 is connected to the ground.

As for the input signal In2 that is inputted from the gate (G1) of the transistoral, thegaincanbeobtained. Therefore, after the signal level is amplified, an output signal OUT1 is outputted from the drain (D) of the transistor a1. When the input signal In2 is inputted into the gate (G1) of the transistor A1, a drain current flows into the gate (G2). The output signal from the gate (G2) of the transistor a1' is outputted to the source (S) side.

Similarly, the gain of the input signal In1 that is inputted from the gate (G1) of the transistor b1 can be obtained. Therefore, after the signal level is amplified, the amplified signal is outputted to the OUT2 from the drain of the transistor b1. In the same way as in the transistor a1', the output signal from the gate (G2) of the transistor b1' is outputted to the source (S) side.

The difference between the level of the input signal of the transistor A1 and that of the transistor B1 that are elements of configuring the differential amplification circuit is amplified and this amplified difference is outputted (from OUT1 and OUT2) as the difference between output signals. Namely, the electric potentials of the outputs OUT1 and OUT2 to the ground (in other words, voltages at both ends of resistors R20 and 21) are respectively outputted as an output voltage.

The configuration such that the circuit of Fig. 4 or Fig. 5 is provided at the subsequent stage of the differential amplification circuit group 20 is adopted. The output signals that are outputted from the OUT1 and OUT2 are outputted to In3 and In4 of Fig. 4 or Fig. 5, respectively. The circuit operations for the input signals that are inputted into the In3 and In4 are explained later using Figs. 4 and 5.

Then, also in the transistor A2 and the transistor B2, an input signal In1 is inputted into the gate (G1) of the transistor a2 while an input signal In2 is inputted into the gate (G1) of the transistor b2, as mentioned before. In the same say as in the case of the source, voltages VDDare applied to the gate (G2) of the transistor b2' and the gate (G2) of the transistor a2'.

In the same way as in the case of the source, voltages VDD are applied to the drain of the transistor b2' and the drain of the transistor a2'.

The signal level of the input signal In1 to the gate (G1) of the transistor a2 is amplified and an output signal OUT1 is outputted from the drain (D) of the transistor a2. Furthermore, the signal level of the input signal In2 to the gate (G1) of the transistor b2 is amplified and an output signal from the drain (D) of the transistor b2 is outputted to the OUT2.

The output signal from the gate (G2) of the transistor a2' is outputted to the source side while the output signal from the gate (G2) of the transistor b2' is outputted to the source (S) side.

The difference between the level of an input signal of the transistor A2 and that of the transistor B2 is amplified and output signals are outputted (from OUT1 and OUT2). Then, the output signal that is outputted from the OUT1 and that from the OUT2 are outputted to In3 and In4 of Fig. 4 or Fig. 5, respectively, as mentioned above. Meanwhile, the circuit operations regarding the input signals that are inputted into the In3 and the In4 are explained later using Figs. 4 and 5.

Regarding the positional relation among the transistors Cn (n is 1 and 2) and the transistors Dn (n is 1 and 2), they are arranged in the same way as the above-mentioned positional relation among the transistors An (n is 1 and 2) and the transistors Bn (n is 1 and 2). Furthermore, they implement the same input-output operations.

As mentioned above, the transistor elements that configure one MOSFET are arranged to sandwich the transistor elements that configure the adjacent MOSFET, thereby configuring a differential amplification circuit.

Meanwhile, as for each transistor (A group, B group, C group and D group), four elements are respectively arranged. However, the number is not restricted to four and any even number is available.

By arranging the respective transistor elements in this way, the differential amplification circuit group 20 in which the wirings on the IC circuit inevitably cross can be configured.

The effect of deteriorating a high frequency property can be obtained by arranging MOSFETs symmetrically while the transistor elements are sandwiched to each other so that a wiring capacity at each wiring position is increased and also by setting large both a channel length (L) and a channel width (W) of the MOSFET so that the gate capacity is increased.

At present, in the case where the amplifier of a radio terminal for handling a high frequency signal is provided with MOSFET, MOSFET having a channel length (L) from approximately 0.7 to 1.0µm and a channel width (W) of about 20µm is used. However, the channel length (L) and the channel width (W) of the MOSFETs that are used in the DC amplifiers 18 and 19 of the present preferred embodiment are set large to the degree that the high frequency property can be deteriorated, as mentioned before. In further detail, it is desirable to deteriorate the high frequency property to the degree that the ratio of the pulsating component to the DC component in an amplifier becomes equal to or less than 20dB. It is further desirable to deteriorate a high frequency property to the degree that the cut-off frequency of an amplifier becomes less than the half of the frequency of the pulsating component or it is further desirable to deteriorate a high frequency property to the degree that the gain of the frequency of the pulsating component attenuates by an amount equal to or greater than 3dB in comparison with the gain in DC (frequency=0) as mentioned above. As concrete numerical values for obtaining such a desirable property, for example, L=5.0µm and W=50µm are adopted.

Namely, by setting both the channel length (L) and the channel width (W) of the MOSFET large, the capacity of the gate (G) of MOSFET (P channel MOSFET) becomes large. As a result, the high frequency properties of the DC amplifiers 18 and 19 deteriorate so that the pulsating component that is included in the input signal and is inputted into the amplifier can be easily removed without using a new capacitor.

Furthermore, It is possible to increase the wiring capacity by arranging the respective transistors as mentioned above, thereby overlapping wirings for connecting among transistors in such a way that they are arranged while sandwiching to each other in the differential amplification circuit group 20 (transistor A group and transistor B group, and transistor C group and transistor D group). Consequently, the effect of deteriorating a high frequency property (the effect of removing a pulsating component) without using a new capacitor can be obtained.

Furthermore, it is possible to decrease an offset voltage by decreasing the difference between ion densities in manufacturing depending on the position of the transistor when ion infusion is implemented in the production process of an IC circuit by symmetrically arranging transistors as mentioned above. In addition, the effect of suppressing errors in manufacturing can be obtained.

Regarding the occurrence of a difference between ion densities on an IC substrate, which is one of the problems in manufacturing in an ion infusion process or in a dispersion process among production processes of IC, the difference between ion densities depending on the position of the MOSFET can be removed by symmetrically arranging MOSFETs. Therefore, the effect of suppressing errors in manufacturing can be obtained even if a difference between ion densities depending on the position of a transistor occurs.

Fig. 4 is the circuit diagram showing one example of the second main part in DC amplifier 18 or 19. The circuit of the same drawing is connected to the subsequent stage of the differential amplification circuit group 20 shown in Fig. 2. In other words, the outputs OUT1 and OUT2 of the differential amplification circuit group 20 that is shown in Fig. 2 are inputted into the input In3 and the In4 that are shown in Fig. 4, respectively.

The circuit as shown in Fig. 4 includes a differential amplification circuit 21 including four MOSFETs (M9, M10, M11 and M12), aMOSFET (M13), a capacitor C10, a resistor R22, a capacitor C11, a constant current source 22 that configures a current mirror circuit, a current source 23 of the differential amplification circuit 21 that configures the current mirror circuit and a current source 24 on the side of an output.

The differential amplification circuit 21 includes four MOSFETs (M9, M10, M11 and M12). Drain voltages VDD are applied to the drains (D) of two MOSFETs (M10 and M12) and the sources (s) of two MOSFETs (M9 and M11) are connected to a current source 23.

The cascade connections between MOSFETs (M9) and (M10), and MOSFETs (M11) and (M12) are implemented.

Then, the signals (In3 and In4) that are inputted into the gates (G) of the MOSFETs (M9) and (M11) are inputted. That is, as explained in Figs. 2 and 3, one output signal OUT1 from the differential amplification circuit group is inputted into the gate G (In3) of the MOSFET (M11) while the other output signal OUT2 is inputted into the gate G (In4) of the MOSFET (M9). Furthermore, the gate (G) of the MOSFET (M10) and that of the MOSFET (M12) are connected to each other. The gate (G) of the MOSFET (M10) is connected to the output side of the drain (D) of the MOSFET (M9).

The intermediate node between the MOSFETs (M11) and (M12) is connected to the gate (G) of a MOSFET (M13) at the subsequent stage.

The signal level of the input signal (In4) to the gate (G) of the MOSFET (M9) is amplified and the amplified signal is outputted from the drain (D) to each of the gates (G) of the MOSFETs (M10) and (M12). Since the signal that is inputted into each of the gates (G) of the MOSFETs (M10) and (M12) is outputted to the source (S), this signal is outputted without being amplified. The outputted signal from the source (S) of the MOSFET (M10) is inputted into the gate (G) of the MOSFET (M12).

Here, by increasing the ratio (L/W) between a channel length (L) and a channel width (W) of the gate (G) of each MOSFET (M9, M10, M11, M12, M13) and setting both a channel length (L) and a channel width (W) large, the capacity of each MOSFET (P channel MOSFET) is increased. Consequently, the high frequency property of eachMOSFET is deteriorated. In this way, the pulsating component that is included in the output signal from the source (S) of each of the MOSFETs (M10 and M12) is removed. The specific operations are as mentioned above.

Then, an input signal (In3) is inputted into the gate (G) of the MOSFET (M11). Since the input signal (In3) is amplified because the gain is obtained and the amplified signal is outputted to the drain (D) side after the pulsating component is removed.

Therefore, the output signals from the MOSFETs (M10 and also M12) are outputted from the differential amplification circuit 21 after the pulsating components are removed.

Then, the output signal that is outputted from the differential amplification circuit 21 is inputted into the gate (G) of the MOSFET (M13) that is provided at the subsequent stage of the differential amplification circuit 21. Meanwhile, a drain voltage VDD is applied to the drain (D) of the MOSFET (M13) and the source (S) is connected to the current source 24.

As shown in Fig. 4, the resistor R22 and the capacitor C10 are connected in series and one end of the capacitor C10 is connected to a source (S) side of the MOSFET (M13) while one end of the resistor R22 is connected to the gate (G) of the MOSFET (M13).

Since the output signal from the MOSFET (M13) is outputted from the source (S) side of the MOSFET (M13), this signal is not amplified and is outputted after the pulsating component is removed. Furthermore, the pulsating component that is included in the feedback signal outputted to the gate (G) of the MOSFET (M13) of the above-mentioned output signal is removed by the capacitor C10.

Here, as mentioned before, the pulsating component that is included in the input signal into each MOSFET is removed as much as possible. Actually, however, some sort of a amplitude change (pulsating component) is generated so that it is desirable to provide a smoothing circuit in the case where the reception electric field level is detected.

As such a smoothing circuit, the capacitor with large capacity C11 as shown in Fig. 4 is externally fixed between the pads (P6 and P8) that are provided at the subsequent stage of the DC amplifiers 18 and 19 and the ground. That is, the capacitor C11 is connected in parallel to the output (OUT in Fig. 4) of the gain control signal required for an AGC operation.

Consequently, by providing the capacitor C11 having a smoothing operation as shown above, the output signal (output signal of the DC amplifier 18) from the differential amplification circuit 21 is certainly smoothed by the capacitor C11 and the smoothed signal is outputted to the buffer amplifier 15 (Fig. 1) at the subsequent stage.

As mentioned before, the pulsating components that are overlapped with the detection signals that are outputted from the amplitude detection circuits 5 and 5' are removed by the DC amplifier group 14 (DC amplifiers 18 and 19) and the detection output is certainly smoothed using the smoothing circuit (capacitor C11). Then, the smoothed signal is inputted into the buffer amplifier 15.

The buffer amplifier 15 outputs the gain control signal required for the gain control on the RF amplification circuit 3 in accordance with the voltage level of the smoothed signal and it further outputs the gain control signal that implements the gain control on the circuit to the AGC diode 17, thereby setting the optimal gains in accordance with the respective reception signal levels. If a pulsating component that cannot be removed by the capacitor C11 remains in each gain control signal, the unnecessary pulsating component is removed certainly by the circuit which includes the capacitor C3 and the resistor R4 and the circuit which includes the capacitor C9 and the resistor R12.

According to the above-mentioned configuration, the pulsating component that is overlapped with the detection output signal from the amplitude detection circuit 5 is removed using the DC amplifier group 14 and the removed component is further smoothed using the capacitor C11. Therefore, the distortion generated in an AGC circuit can be effectively removed. The DC amplifiers 18 and 19 are provided immediately after the amplitude detection circuits 5 and 5' so that they can certainly prevent high frequency components from being radiated and propagated from the circuit pattern by an IC circuit.

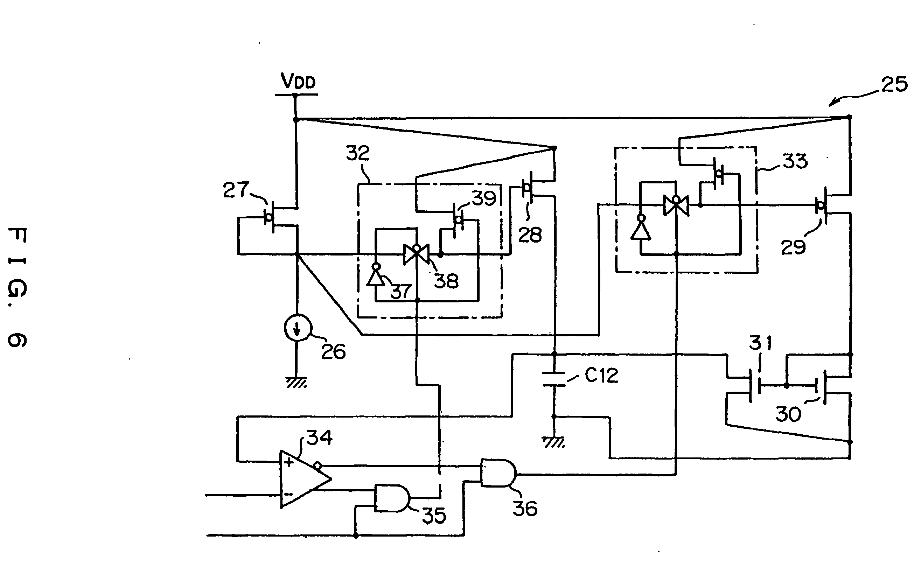

Fig. 5 is the circuit diagram showing another example of the second main part in each of the DC amplifiers 18 and 19. Fig. 6 is the specific circuit diagram of the smoothing circuit 25 that is shown in Fig. 5.

In the circuit of Fig. 5, the smoothing circuit 25 is used instead of the capacitor C11 which is used in the circuit of Fig. 4. Therefore, only this smoothing circuit 25 is explained here. Meanwhile, in Fig. 5, the same elements as shown in Fig. 4 are denoted by the same reference codes.

The process until the input signal is inputted into the smoothing circuit 25 is the same as that in the circuit of Fig. 4.

As shown in Fig. 6, the smoothing circuit 25 includes a capacitor C12, a constant current circuit 26, transistors 27, 28, 29, 30 and 31, switches 32 and 33, voltage comparison device 34 and AND circuits 35 and 36. As mentioned above, the pulsating component of the input signal into MOSFET in Fig. 5 is removed as much as possible. Actually, however, some sort of a amplitude change (pulsating component) is generated. Therefore, it is desirable to provide a smoothing circuit in the case where a reception electric field level is detected. Consequently, the output signal is certainly smoothed by providing the smoothing circuit 25 at the subsequent stage of the DC amplifiers 18 and 19.

In a smoothing circuit 25, a current mirror circuit includes two transistors 27 and 28 as shown in Fig. 6 and this circuit generates a charging current the amount of which is the same as that of a constant current that is outputted from the constant current circuit 26. Furthermore, the timing of the generation of this charging current is determined by the switch 32.

The switch 32 includes an inverter circuit 37, an analogue switch 38 and a transistor 39.

The analogue switch 38 is configured by connecting in parallel between the source and drain of a P channel transistor and between the source and drain of an N channel transistor.

The signal that is obtained by inverting the logic of the output signal of the AND circuit 35 using an inverter circuit 37 is outputted to the gate of the P channel transistor. Therefore, this analogue switch 38 turns ON when the output signal of the AND circuit 35 is at high level while it turns OFF when the output signal is at low level. Furthermore, the transistor 39 certainly suspends the current supply operation using the transistor 28 by connecting using low resistor between the gate and the drain of the transistor 28 when the analogue switch 38 is OFF.

When the switch 32 turns ON, the gate of one transistor 27 that is connected to the constant current circuit 26 is further connected to the gate of the other transistor 28. Therefore, the current the amount of which is the same as that of a constant current generated by the constant current circuit 26 that is connected to the other transistor 27 flows between the source and the drain of the other transistor 28. This current is supplied to the capacitor C12 as a charging current. On the other hand, when the switch 32 turns OFF, the gate of the transistor 28 is connected to a drain thereof so that the supply of this charging current is stopped.

The above-mentioned constant current circuit 26 and two transistors 27 and 28 correspond to a current supply unit. The switch 32 and the AND circuit 35 correspond to the first timing control unit.

In addition, a current mirror circuit for setting a discharge current of the capacitor C12 is configured by combining the transistor 29 with both the transistor 27 and the constant current circuit 26, and the operation condition is determined by the switch 33. The switch 33 has the same configuration as that of the switch 32. In respect of this switch 33, the ON and OFF conditions are controlled in accordance with the logic of the output signal of the AND circuit 36. The switch turns ON when this output signal is at high level while it turns OFF when this output signal is at low level.

When the switch 33 turns ON, the gate of one transistor 27 that is connected to the constant current circuit 26 is connected to the gate of the other transistor 29 so that the current the amount of which is approximately the same as that of the constant current that is generated by the constant current circuit 26 flows between the source and the drain of the other transistor 29. This current becomes a discharge current that discharges the accumulated electric charges in the capacitor C12.

However, since the current that flows in the transistor 29 cannot be taken out directly from the capacitor C12, another current mirror circuit that includes transistors 30 and 31 is connected to a source side of the transistor 29 according to the preferred embodiment of the present invention.

The gates of the two transistors 30 and 31 are connected to each other. When the discharge current flows in one transistor, the same current flows between the source and the drain of the other transistor. In respect of the transistor 31, the drain is connected to the terminal on the side of the high potential of the capacitor C12. The current that flows in the transistor 31 is generated by discharging the electric charges that are accumulated in the capacitor C12.

Each of the constant current circuit 26 and the four transistors 27, 29, 30 and 31 corresponds to a current discharge unit. Each of the switch 33 and the circuit 36 corresponds to the second timing control unit.

In addition, the voltage comparison device 34 compares the terminal voltage of the capacitor C12 that is applied to a plus terminal with the input voltage of the smoothing circuit 25 that is applied to the minus terminal. This voltage comparison device 34 has a noninversion output terminal and an inversion output terminal. In the case where the input voltage is greater than the terminal voltage of the capacitor C12 that is applied to the plus terminal, the signal at high level is outputted from the noninversion output terminal while a signal at low level is outputted from an inversion output terminal. On the contrary, in the case where the terminal voltage of the capacitor C12 that is applied to the plus terminal is lower than the input voltage that is applied to the minus terminal, a signal at low level is outputted from the noninversion output terminal while a signal at high level is outputted from the inversion output terminal.

In the AND circuit 35, a predetermined signal is inputted into one input terminal while the noninversion input terminal of the voltage comparison device 34 is connected to the other input terminal. Therefore, in the case where the terminal voltage of the capacitor C12 is greater than the input voltage of the smoothing circuit 25, the predetermined signal is outputted from the AND circuit 35.

Furthermore, in the AND circuit 36, the predetermined signal is inputted into one input terminal while the inversion input terminal of the voltage comparison device 34 is connected to the other input terminal. Therefore, in the case where the terminal voltage of the capacitor C12 is lower than the input voltage of the smoothing circuit 25, the predetermined signal is outputted from the AND circuit 36.

The following is the explanation about the operations of the smoothing circuit 25 that is configured in this way.

The gain control signals that are outputted from the DC amplifiers 18 and 19 are inputted into the voltage comparison device 34 and the AND circuit 35.

In the case where the capacitor C12 is not charged at the time of starting the operation of the smoothing circuit 25 or in the case where the input voltage of the smoothing circuit 25 shows an upward tendency, the terminal voltage of the capacitor C12 is in a lower condition than the input voltage of the smoothing circuit 25. At this time, a signal is outputted from the AND circuit 35 but a signal is not outputted from the AND circuit 36. Therefore, only the switch 32 turns ON at intervals and the predetermined charge current is supplied to the capacitor C12 at the timing when the switch turns ON. This charging operation is continued until the terminal voltage of the capacitor C12 becomes relatively higher than the input voltage of the smoothing circuit 25.

In the case where the terminal voltage of the capacitor C12 exceeds the input voltage of the smoothing circuit 25 by this charging operation or in the case where this input voltage shows a downward tendency and it is lower than the terminal voltage of the capacitor C12, a signal is outputted from the AND circuit 36 but a signal is not outputted from the AND circuit 29. Therefore, only the switch 33 turns ON at intervals and the predetermined discharge current is discharged from the capacitor C12 at the timing when the switch turns ON. This discharge operation is continued until the terminal voltage of the capacitor C12 becomes relatively lower than the input voltage of the smoothing circuit 25.

Furthermore, it is appropriate to set the duty ratio of the signal that is inputted into anAND circuit smaller than the cycle and the duty ratio of the signal that determines the supply timing of a charge current and also the duty ratio of the signal that determines the supply timing of a discharge current, in the smoothing circuit 25 that is shown in Fig. 6. In this way, a release time can be set longer than an attack time.

Since the capacitor C21 is discharged or charged at intervals as mentioned before, the terminal voltage can be gradually changed even in the case where the capacitor C12 with a comparatively small capacity is used, thereby setting a substantially large time constant. Consequently, the smoothing circuit 25 that can implement a sufficient smoothing operation is materialized.

If such the smoothing circuit 25 is adopted, the capacitor C12 with a small capacity can be used even in the case where a large time constant is set. Therefore, the miniaturization of the circuit can be realized. Furthermore, the large resistor and capacitor that are required for the setting of a large time constant are not required so that all or some externally-mounted components can be eliminated. Accordingly, whole the smoothing circuit 25 or most of components thereof can be incorporated into each of the DC amplifiers 18 and 19 to be an IC.

Meanwhile, the present invention is not limited to the above-mentioned preferred embodiments so that various configuration changes can be made within the scope of the gist of the present invention described in claims.

For example, according to the above-mentioned preferred embodiment of the present invention, as a removal unit of removing the high frequency component (pulsating component) that is included in the detection outputs of the detection circuits 5 and 5' is configured by appropriately combining some or all the following units of a) a unit in which the channel length and the channel width of MOSFET configuring each of the DC amplifiers 18 and 19 are set large; b) a unit in which the capacitors C11 with large capacity (Fig. 4) are provided at output terminals of the DC amplifiers 18 and 19; c) a unit in which original smoothing circuits 25 (Figs. 5 and 6) are provided at output terminals of the DC amplifiers 18 and 19; and d) a unit in which MOSFETs configuring the DC amplifiers 18 and 19 are arranged in such a way the wirings between these MOSFETs are crossed with each other. If these units are individually adopted, a remarkable effect can be expected and such adoption falls within the scope of the present invention.

As mentioned before, it is desirable to deteriorate the high frequency property up to the degree that the gain in a frequency of the pulsating component attenuates by an amount equal to or greater than 3dB in comparison with the gain in a DC current (frequency=0). However, the present invention is not limited to this.

### Industrial Applicability

The present invention is applied to an AGC circuit provided in an RF receiver like, for example, an FM radio receiver and this circuit is suitable for integrating the whole circuit into an IC.

## Claims

1. An AGC circuit comprising a detection circuit that detects a high frequency reception signal and outputs a detection signal including a pulsating component, and controlling a gain of an amplification circuit amplifying the high frequency reception signal according to a detection output of the detection circuit, wherein:
a high frequency property of an amplifier that is connected immediately after the detection circuit is deteriorated; or
a unit for deteriorating the high frequency property is connected to the amplifier.

2. The AGC circuit according to claim 1, wherein
the amplifier whose high frequency property is deteriorated is configured in such a way that a channel length and a channel width in each MOSFET that configures the amplifier are set large up to a degree that the high frequency property of the amplifier deteriorates.

3. The AGC circuit according to claim 1, wherein
the unit for deteriorating the high frequency property is a capacitor with large capacity that is connected between an output terminal of the amplifier and ground.

4. The AGC circuit according to claim 1, wherein:
the unit deteriorating the high frequency property is a smoothing circuit comprising:
a capacitor;
a voltage comparison circuit for comparing a terminal voltage with an input voltage of the capacitor;
a charge circuit for charging the capacitor at intervals in a case where the input voltage is relatively higher than the terminal voltage; and
a discharge circuit for discharging a discharge current at intervals from the capacitor in a case where the terminal voltage is relatively lower than the input voltage; and
the smoothing circuit is connected to an output terminal of the amplifier.

5. The AGC circuit according to claim 1, wherein
the amplifier whose high frequency property is deteriorated is configured to increase a wiring capacity up to a degree that the high frequency property of the amplifier deteriorates by arranging respective MOSFETs that configure the amplifier in such a way that wirings among the MOSFETs are crossed with each other.

6. The AGC circuit according to one of claims 1 to 5, wherein
deterioration of the high frequency property is deterioration by an amount equal to or greater than 3dB in a frequency of the pulsating component.
